(19)

Europäisches
Patentamt
European
Patent Office
Office européen
des brevets

(11) **EP 4 407 871 B1**

(12) **EUROPEAN PATENT SPECIFICATION**

(45) Date of publication and mention
of the grant of the patent:
**26.03.2025 Bulletin 2025/13**

(21) Application number: **23153168.2**

(22) Date of filing: **24.01.2023**

(51) International Patent Classification (IPC):
*H03K 17/06* (2006.01)    *H03K 17/082* (2006.01)
*H03K 17/0812* (2006.01)

(52) Cooperative Patent Classification (CPC):
**H03K 17/063;** H03K 17/08122; H03K 17/0822;
H03K 2017/066

(54) **ELECTRONIC CIRCUIT WITH A TRANSISTOR DEVICE AND A PROTECTION CIRCUIT**

ELEKTRONISCHE SCHALTUNG MIT EINER TRANSISTORVORRICHTUNG UND EINER
SCHUTZSCHALTUNG

CIRCUIT ÉLECTRONIQUE AVEC UN DISPOSITIF À TRANSISTOR ET UN CIRCUIT DE
PROTECTION

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(43) Date of publication of application:
**31.07.2024 Bulletin 2024/31**

(73) Proprietor: **Infineon Technologies Austria AG
9500 Villach (AT)**

(72) Inventor: **NÖBAUER, Gerhard
9500 Villach (AT)**

(74) Representative: **Westphal, Mussgnug & Partner,
Patentanwälte mbB
Werinherstraße 79
81541 München (DE)**

(56) References cited:
**EP-A1- 2 320 544    US-A- 4 677 324
US-A- 5 929 665**

**Description**

This disclosure relates in general to an electronic circuit with a transistor device, in particular an insulated gates transistor device.

Insulated gate transistor devices such as MOSFETs or IGBTs are widely used as electronic switches in various kinds of electronic circuits. Examples of such circuits include switched-mode power supplies, motor drive circuits, or inverters to name only a few.

An insulated gate transistor device is a voltage-controlled transistor device that is configured to switch on and off dependent on a drive voltage received at a drive input. In the on-state, the transistor device is configured to conduct a current through a load path. In the off-state, the transistor device is configured to block.

Inevitably, in an insulated gate transistor device, the load path is capacitively coupled with the drive input. In a MOSFET, for example, a drain node, which is part of the load path, is capacitively coupled with the gate node, which is part of the drive input.

The capacitive coupling between the load path and the drive input may have the effect that the transistor device erroneously switches on after having been switched off. More specifically, switching off the transistor device may cause a voltage across the load path to rapidly increase, which may cause the electrical potential at the drain node to rapidly increase. Due to the capacitive coupling between the load path and the drive input, such rapid increase of the potential at the drain node may cause a voltage spike at the gate node that causes the transistor device to switch on. This is highly undesirable.

There is therefore a need to protect a transistor device, in particular an insulated gate transistor device, from erroneously switching on due to a rapidly increasing voltage across the load path. This problem is already addressed in US 4 677 324 A, which proposes a solution different from the present invention.

One example relates to an electronic circuit. The electronic circuit includes a first transistor device and a protection circuit. The first transistor device includes a first drive node, a second drive node, and a load path. The protection circuit is coupled to the first and second drive nodes and the load path of the first transistor device. The protection circuit includes a second transistor device having a first drive node, a second drive node, and a load path. Furthermore, the protection circuit includes a capacitor coupled between the load path of the first transistor device and the first drive node of the second transistor device. The load path of the second transistor device is connected between the first and second drive nodes of the first transistor device. A capacitance of the capacitor is voltage dependent such that the capacitance decreases as a voltage across the capacitor increases.

Another example relates to a method. The method includes switching off a first transistor device protection circuit. The transistor device includes a first drive node, a second drive node, and a load path. The protection circuit is coupled to the first and second drive nodes and the load path of the first transistor device. The protection circuit includes a second transistor device comprising a first drive node, a second drive node, and a load path connected between the first and second drive nodes of the first transistor device, and a capacitor coupled between the load path of the first transistor device and the first drive node of the second transistor device, wherein the capacitance of the capacitor is voltage dependent such that the capacitance decreases as a voltage across the capacitor increases.

Examples are explained below with reference to the drawings. The drawings serve to illustrate certain principles, so that only aspects necessary for understanding these principles are illustrated. The drawings are not to scale. In the drawings the same reference characters denote like features.

Figure 1 illustrates one example of an electronic circuit that includes a first transistor device and a protection circuit with a second transistor device, a voltage dependent capacitor, and a resistor;

Figure 2 shows curves that illustrate voltage dependent capacitances of different types of voltage dependent capacitors;

Figure 3 shows a circuit symbol of a voltage dependent capacitor according to one example;

Figures 4-5 illustrate a perspective sectional view and a horizontal sectional view of one example of the first transistor device;

Figures 6-9 illustrate different examples of the voltage dependent capacitor;

Figures 10-14 illustrate different examples of the resistor;

Figures 15A-15B and 16 illustrate one example of the second transistor;

Figure 17 illustrates a top view of a semiconductor body according to one example in which the electronic circuit is integrated;

Figure 18 illustrates one example for implementing the electronic circuit in the semiconductor body according to Figure 17;

Figure 19 illustrates a top view of a semiconductor body according to another example in which the electronic circuit is integrated; and

Figure 20 illustrates one example for implementing the electronic circuit in the semiconductor body according to Figure 19.

In the following detailed description, reference is made to the accompanying drawings. The drawings form a part of the description and for the purpose of illustration show examples of how the invention may be used and implemented.

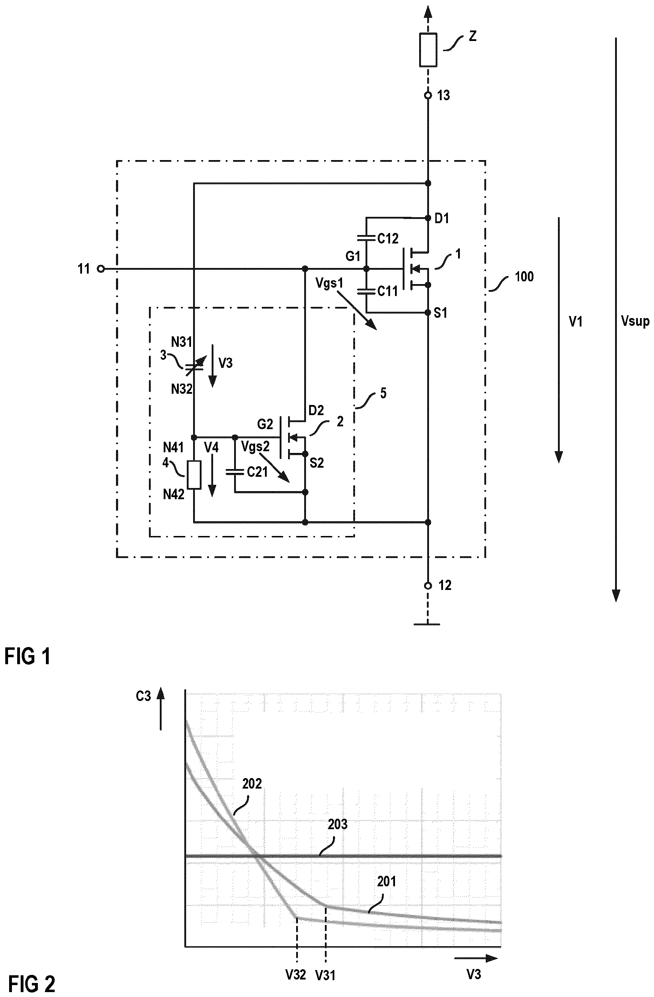

Figure 1 shows a circuit diagram of an electronic circuit according to one example. The electronic circuit includes a first transistor device 1 and a protection circuit 5. The first transistor device 1 includes a first drive node G1, a second drive node S1, and a load path D1-S1. The protection circuit 5 includes a second transistor device 2 with a first drive node G2, a second drive node S2, and a load path D2-S2. Furthermore, the protection circuit 5 includes a capacitor 3 coupled between the load path D1-S1 of the first transistor device 1 and the first drive node G2 of the second transistor device 2. The load path D2-S2 of the second transistor device 2 is connected between the first and second drive nodes G1, S1 of the first transistor device 1. Furthermore, the capacitor 3 of the protection circuit 5 is selected such that its capacitance decreases as a voltage V3 across the capacitor 3 increases V3.

The first transistor device 1 may be used as an electronic switch that controls a voltage across any type of load or circuit element connected in series with the load path D1-S1 of the first transistor device 1. For this, as illustrated in dashed lines in Figure 1, the load path D1-S1 of the first transistor device 1 may be connected in series with the load or circuit element Z, wherein the series circuit including the first transistor device 1 and the load or circuit element Z is connected to a power source that provides a supply voltage Vsup. The load or circuit element, which is represented by reference character Z in Figure 1, may be any type of load, such as a light, a magnetic valve, or the like, or any type of circuit element, such as an inductor in a switched-mode power supply. According to one example, the transistor device 1 is used as an electronic switch in a switched-mode power supply (SMPS).

As illustrated in Figure 1, the load or circuit element Z may be connected between the transistor device 1 and a first supply node of the power supply, so that the transistor device 1 may operate as a low-side switch. This, however, zone an example. It is also possible to connect the transistor device 1 between the first supply node and the load Z, so that the transistor device 1 may operate as a high-side switch. Furthermore, it is possible to implement the transistor device 1 as part of an electronic circuit in which one or more elements of the circuit are connected between the transistor device 1 and the first supply node and or more other elements of the electronic circuit are connected between the transistor device 1 and a second supply node of the power source.

The first transistor device 1 is configured to switch on in order to be in an on-state, or to switch off in order to be in an off-state. In the on-state, the load path D1-S1 of the first transistor device 1 is conducting, so that a voltage V1 across the load path D1-S1 is essentially zero and a voltage across the load or circuit element Z essentially equals the supply voltage Vsup. In the off-state, the load path D1-S1 of the first transistor device 1 is blocking, so that the voltage V1 across the load path D1-S1 of the first transistor device 1 essentially equals the supply voltage Vsup.

The first transistor device 1 switches on or off dependent on a drive voltage Vgs1 received between the first drive node G1 and the second drive node S1. The load path D1-S1 is a circuit path between a first load path node D1 and a second load path node S1. Just for the purpose of illustration, in the first transistor device 1 according to Figure 1, the second drive node and the second load path node are formed by the same circuit node of the first transistor device 1. This, however, is only an example. It is also possible to implement the first transistor device 1 such that the second drive node and the second load path node are different circuit nodes of the first transistor device 1. In this example, the protection circuit 5 may be connected to both the second drive node and the second load path node.

Just for the purpose of illustration, the first transistor device according to Figure 1 is a MOSFET, in particular an N-type enhancement MOSFET. In this example, the drive node G1 is a gate node of the MOSFET, the first load path node D1 is a drain node of the MOSFET, and the second drive node and second load path node S1 is a source node of the MOSFET.

Referring to Figure 1, the first load path node D1 and the drive node G1 of the first transistor device 1 are capacitively coupled, wherein such capacitive coupling is represented by a capacitor C12 connected between the first load path node D1 and the first drive node G1. In a MOSFET, for example, this capacitor C12 is formed by an inherent gate-drain capacitance of the MOSFET. In addition to the gate-drain capacitance, the MOSFET may include a gate-source capacitance, which is represented by capacitor C11 connected between the gate node G1 and the source node S1 in Figure 1.

The first transistor device 1 may be implemented in such a way that it switches on when the drive voltage Vgs1 received between the first and second drive nodes G1, S1 reaches a predefined positive voltage threshold (that is usually referred to as threshold voltage), and switches off when the drive voltage Vgs1 falls below the threshold voltage. The drive voltage may be generated by a drive circuit (not illustrated in Figure 1). An N-type enhancement MOSFET is one example of a transistor device that operates in this way.

When the first transistor device 1 switches from the on-state, in which the voltage V1 across the load path D1-S1 is essentially zero, to the off-state, in which the voltage V1 across the load path D1-S1 essentially equals the supply voltage Vsup, an electrical potential at the first load path node D1 may rapidly increase. Due to the capacitive coupling between the first load path node D1 and the first drive node G1 such rapid increase of the electrical potential at the first load path node D1 may cause an increase of the electrical potential at the first drive node G1, wherein such increase of the electrical potential at the first drive node G1 may have the effect that the drive voltage Vgs1, which is supposed to be below the threshold voltage in the off-state, rises above the threshold, so that the first transistor device unintentionally switches on.

Such unintended switching on of the first transistor device 1 is highly undesirable. In the electronic circuit according to Figure 1, the protection circuit 5 is configured to protect the first transistor device 1 from unintentionally switching on when the switching state changes from the on-state to the off-state.

In the protection circuit 5 according to Figure 1, the second transistor device 2, which has its load path D2-S2 connected between the first and second drive nodes G1, S1 of the first transistor device 1, can be operated in an on-state or an off-state. In the on-state, the load path D2-S2 of the second transistor device 2 is conducting, so that the second transistor device 2 essentially clamps the drive voltage Vgs1 of the first transistor device 1 to zero, so that the drive voltage Vgs1 is below the threshold voltage and the first transistor device 1 is maintained in the off-state. In the off-state of the second transistor device, the load path D2-S2 is blocking, so that the drive voltage Vgs1 of the first transistor device 1, governed by a drive circuit (not illustrated), may rise above the threshold voltage, so that the first transistor device 1 switches on.

The second transistor device 2 switches on or off dependent on a drive voltage Vgs2 received between a first drive node G2 and a second drive node S2, wherein the second drive node S2 and the second load path node S2 of the load paths D2-S2 may be formed by the same circuit node of the second transistor device 2. Referring to Figure 1, the second transistor device 2 may include an inherent capacitance between the first and second drive nodes G2, S2. This capacitance, which is referred to as drive capacitance in the following, is represented by capacitor C21 in Figure 1. The second transistor device 2 may be implemented such that it switches on when the drive voltage Vgs2 rises above a predefined threshold voltage and switches off when the drive voltage Vgs2 falls below the threshold voltage. The threshold voltage is a positive voltage according to one example.

The second transistor device 2 may be implemented as a MOSFET, in particular an N-type enhancement MOSFET. In this example, the drive capacitance is formed by a gate-source capacitance of the MOSFET. An N-type enhancement MOSFET is a transistor device having a positive threshold voltage. A gate node of the MOSFET forms the first drive node G1, a drain node of the MOSFET forms the first load path node D1, and a source node of the MOSFET forms the second drive node and second load path node S2.

Referring to Figure 1, the drive capacitance C21 of the second transistor device 2 and the capacitor 3 of the protection circuit 5 form a capacitive voltage divider connected in parallel with the load path D1-S1 of the first transistor device 1. When the first transistor device 1 switches from the on-state to the off-state, so that the voltage V1 across the load path D1-S1 rapidly increases, a capacitive displacement current flows into the capacitive voltage divider formed by the capacitor 3 and the drive capacitance C21 of the second transistor device 2. This capacitive displacement current charges the drive capacitance C21 of the second transistor device 2. In this way, the second transistor device 2 switches on when the voltage V1 across the load path D1-S1 the first transistor device rapidly increases, so that the first transistor device 1 is maintained in the of state.

Referring to the above, the capacitor 3 of the protection circuit 5 has a voltage dependent capacitance such that the capacitance decreases as a voltage V3 across the capacitor 3 increases. The drive capacitance C21 of the second transistor device 2 is essentially constant and independent of the drive voltage Vgs2. The voltage V3 across the capacitor 3 and the drive voltage Vgs2 are each a portion of the load path voltage V1, wherein the drive voltage Vgs2 is given by

$$Vgs2 = \frac{C3}{C21+C3} \cdot V1 \qquad (1),$$

and wherein the voltage V3 across the capacitance C3 is given by

$$V3 = \frac{C21}{C21+C3} \cdot V1 \qquad (2),$$

where C21 denotes the capacitance of the drive capacitance of the second transistor device 2, C3 denotes the capacitance of the capacitor 3, V3 denotes the voltage across the capacitor, V1 denotes the load-path voltage of the first transistor device 1, and Vgs2 denotes the drive voltage of the second transistor device 2. Furthermore, a ratio between the drive voltage Vgs2 of the second transistor device 2 and the voltage V3 across the capacitor 3 is given by

$$\frac{Vgs2}{V3} = \frac{C3}{C21} \qquad (3).$$

As can be seen from equations (1)-(3) the lower of the capacitance C3 of the capacitor 3 the lower the portion of the load path voltage V1 that forms the drive voltage Vgs2. Thus, given that the capacitance of the capacitor 3 increases as the voltage V3 increases, the portion of the load path voltage V1 that forms the drive voltage Vgs2 decreases as the load path voltage V1 increases. Thus, when the load path voltage V1 is low, a relatively high portion of the load path voltage V1 drops across the drive capacitance of the second transistor device 2, and when the load path voltage V1 is high, a relatively low portion of the load path voltage V1 drops across the drive capacitance of the second transistor device 2. In this way, the drive capacitance C21 is rapidly charged at the beginning of the transition process in which the first transistor device 1 changes from the on-state to the off- state and the load path voltage V1 increases, so that the second transistor device 2 rapidly switches on in order to maintain the first transistor device 1 in the off-state. Furthermore, when the load path voltage V1 increases, the drive capacitance C21 of the second transistor device 2 is protected against high voltages as the capacitor 3 of the protection circuit 5 takes over most of the load path voltage V1. Which portion of the load path voltage V1 is taken over by the capacitor 3 when the load path voltage V1 reaches the supply voltage level is dependent on the dimensioning of the capacitor C3 and the drive capacitance C21 of the second transistor device 2 and can be adjusted by suitably selecting the capacitor 3.

According to one example, the capacitor 3 is configured to withstand essentially the same voltage as the first transistor device 1 in the blocking state. According to one example, a voltage blocking capability of the first transistor device 1 is in the range of between 0 volts (V) and 200 V, for example.

According to one example, a resistor 4 is connected in parallel with the drive capacitance C21 of the second transistor device 2. The resistor 4 discharges the drive capacitance C21 of the second transistor device 2 after the transition of the first transistor device 1 from the on-state to the off-state in order to switch off the second transistor device 2. The time duration it takes to discharge the drive capacitance C21 such that the drive voltage Vgs2 falls below the threshold voltage of the second transistor device 2 and the second transistor device 2 switches off can be adjusted by suitably adjusting a resistance of the resistor 4 in view on the drive capacitance C21. Basically, at a given drive capacitance C21, the higher the resistance of the resistor 4 the longer it takes for the drive capacitance C21 to be discharged.

Referring to Figure 1, the electronic circuit includes three (external) terminals, wherein each of these terminals is connected to a respective one of the three circuit nodes of the first transistor device 1. A first terminal 11 is connected to the first drive node G1 of the first transistor device 1, a second terminal 12 is connected to the second drive node and second load path node S1 of the first transistor device 1, and a third terminal 13 is connected to the first load path node D1 of the first transistor device 1. The drive voltage Vgs1 of the first transistor device 1 is a voltage received between the first and second terminals 11, 12. The electronic circuit operates as a transistor device that is protected from unintentionally switching on.

According to one example, the electronic circuit is integrated in one single semiconductor body 100. This is schematically illustrated in dashed-and-dotted lines in Figure 1 and is explained in detail herein further below. The semiconductor body 100 may include a conventional semiconductor material, such as silicon (Si) or silicon carbide (SiC).

Figure 2 illustrates examples of a voltage dependency of a capacitance C3 of the capacitor 3. Curves 201, 202 illustrate two different examples in which the capacitance C3 decreases as the voltage V3 across the capacitor 3 increases. In a first example represented by curve 201 the capacitance C3 decreases slower as the voltage V3 increases than in a second example represented by curve 202. The characteristic of the capacitor 3, that is, the way in which the capacitance C3 decreases as the voltage V3 increases can be adjusted in the way explained herein before.

For the purpose of illustration, curve 203 illustrated in Figure 2 represents a conventional capacitor in which the capacitance is essentially constant and independent of a voltage across the capacitor.

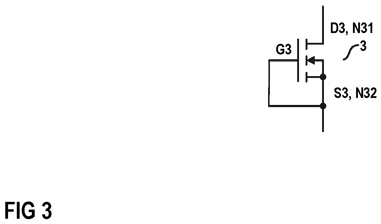

The capacitor 3 can be implemented in various ways. According to one example illustrated in Figures 3, the capacitor 3 is implemented as a MOSFET, wherein a gate node G3 of the MOSFET is connected to a source node S3 of the MOSFET. A drain node D3 of the MOSFET forms a first capacitor node N31 that, referring to Figure 1, is connected to the first load path node D1 of the first transistor device. The source node S3 of the MOSFET forms a second capacitor node N32 that, referring to Figure 1, is connected to the drive node G3 of the second transistor device. According to one example, the MOSFET forming the capacitor 3 is of the same type as a MOSFET forming the first transistor device 1. According to one example (as illustrated in the drawings) these MOSFETs are N-type enhancement MOSFETs.

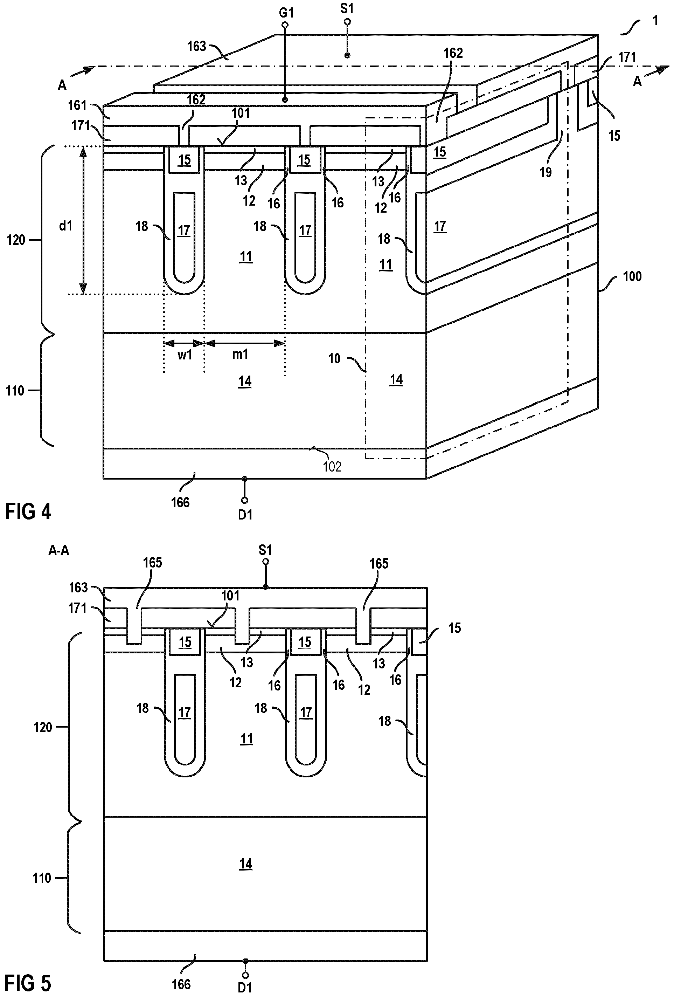

Figure 4 illustrates one example for implementing the first transistor device 1. More specifically, Figure 4 schematically illustrates a perspective sectional view of one section of a semiconductor body 100 in which the first transistor device 1 is integrated. The first transistor device is a MOSFET in this example.

Referring to Figure 4, the transistor device 1 may include a plurality of transistor cells 10, wherein each transistor cell includes a drift region 11 of a first doping type (conductivity type), a body region 12 of a second doping type complementary to the first doping type and separating a source region 13 of the first doping type from the drift region 11, and a drain region 14 of the first doping type. Furthermore, each transistor cell 10 includes a gate electrode 15 that is dielectrically insulated from the body region 12 by a gate dielectric 16 and is configured to control a conducting channel in the body region 12 along the gate dielectric 16 between the source region 13 and the drift region 11.

The gate electrodes 15 are trench electrodes in the example illustrated in Figure 4. That is, the gate electrodes 15 are arranged in trenches that, from a first surface 101 of the semiconductor body 100, extend into the semiconductor body 100.

Referring to Figure 4, each transistor cell 10 may further include a field electrode 17 that is dielectrically insulated from the drift region 11 by a field electrode dielectric 18. In the example illustrated in Figure 4, the gate electrode 15 and the field electrode 17 of each transistor cell 10 are arranged in the same trench and insulated from one another, wherein, as seen from the first surface 101, the field electrode 17 is located below the gate electrode 15. This, however, is only an example. It is also possible, to implement the gate electrode 15 and the field electrode 17 of each transistor cell 10 in different trenches that are spaced apart from each other in a lateral direction of the semiconductor body 100. A "lateral direction" is a direction that is essentially parallel to the first surface 101.

Referring to the above, the first transistor device 1 may be implemented as an N-type MOSFET. In this example, the first doping type is an N-type and the second doping type is a P-type.

Referring to Figure 4, the first transistor device 1 may be implemented as a vertical transistor device. In this example, the source and drain regions 13, 14 of the transistor cells 10 are spaced apart from each other in a vertical direction of the semiconductor body 100. The "vertical direction" is a direction that is essentially perpendicular to the first (main) surface 101 of the semiconductor body 100.

Referring to Figure 1, the first transistor device 1 further includes a gate conductor 161, wherein the gate conductor 161 forms the drive node (gate node) G1 or is connected to the drive node G1 of the first transistor device 1. The gate electrodes 15 of the individual transistor cells 10 are connected to the gate conductor 161. The gate conductor 161 may be formed on top of an insulating layer 171, wherein the insulating layer 171 is formed on top of the first surface 101 of the semiconductor body 100 and separates the gate conductor 161 from the semiconductor body 100. The gate conductor 162 may be connected to the gate electrodes 15 through gate vias 162. The gate vias 162 extend from the gate conductor 161 through the insulating layer 171 to the gate electrodes 15.

The first transistor device 1 further includes a source electrode 163, wherein the source electrode 163 is connected to the second drive node (second load path node, source node) S2 or forms the second drive node S2. The field electrodes 18 and the source regions 13 of the individual transistor cells 10 are connected to the source electrode 163. One way of connecting the field electrodes 17 to the first electrode 163 is illustrated in Figure 5.

Figure 5 shows a vertical cross-sectional view of the semiconductor body 100 in a section plane A-A illustrated in Figure 5. In the example illustrated in Figure 5, the source electrode 163 is arranged on top of the insulating layer 171. Referring to Figure 5, the source regions 13 and the body regions 12 of the individual transistor cells 10 are connected to the source electrode 163 through source vias 165 that extend from the source electrode 163 through the insulating layer 171 down to the source and body regions 13, 12.

Referring to Figure 4, the gate electrodes 15 and the field electrodes can be implemented as elongated electrodes that longitudinally extend in a lateral direction of the semiconductor body 100. Each field electrode 17 may include a contact section 19 that extends to the first surface 101 where the field electrode section 19 is connected to an electrically conducting via. The electrically conducting via extends through the insulating layer 171 and connects the contact section 19 of the field electrode 17 to the source electrode 163. Referring to Figure 4, the contact section 19 extends towards the first surface 101 between two gate electrodes 15, wherein each of these gate electrodes 15 is connected to a respective gate conductor 161 (only one of these gate conductors is illustrated in Figure 4).

Referring to Figure 4, the drift regions 11 of the transistor cells 10 may be formed by one contiguous semiconductor region of the first doping type. Furthermore, the drain regions 14 of the individual transistor cells 10 may be formed by one contiguous semiconductor region of the first doping type. According to one example, the semiconductor region forming the drain regions 14 of the transistor cells 10 is formed by a first semiconductor layer 110 on top of which a second semiconductor layer 120 is formed. According to one example, the first semiconductor layer 110 is a semiconductor substrate and the second semiconductor layer 120 is an epitaxial layer. According to one example, the second semiconductor layer 120 has a basic doping of the first doping type, wherein the semiconductor region forming the drift regions 11 is a region having the basic doping of the epitaxial layer 120. The source and body regions 13, 12 may be formed by implanting and/or diffusing dopant atoms into the second semiconductor layer 120.

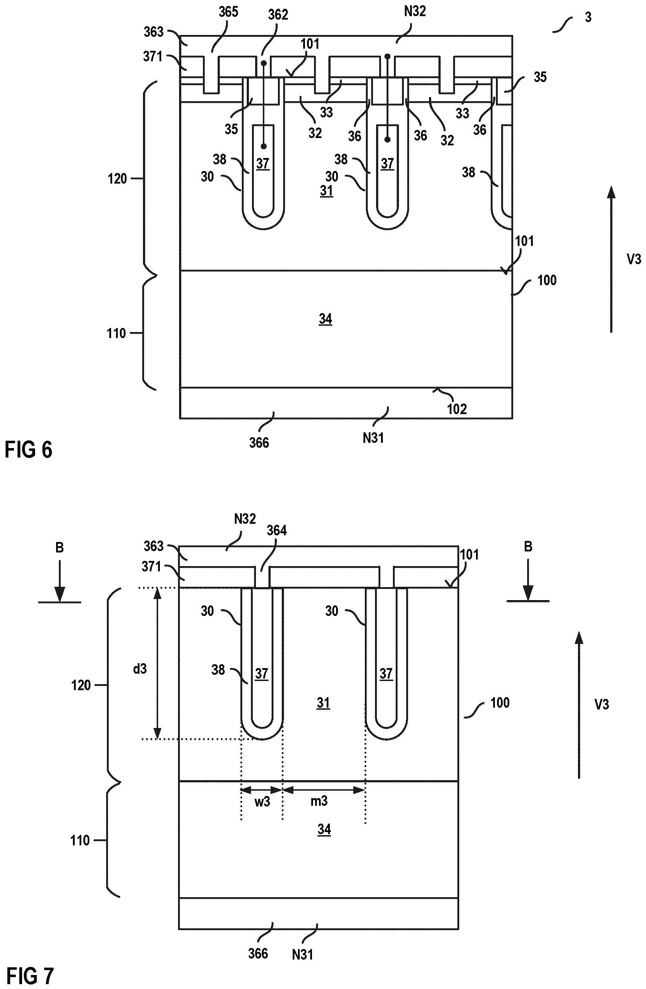

Figure 6 illustrates one example of the capacitor 3 of the protection circuit 5. As explained hereinabove, the capacitor 3 and the first transistor device 1 may be integrated in the same semiconductor body 100. Figure 6 shows a vertical cross-sectional view of one section of the semiconductor body 100 in which the capacitor 3 is integrated.

The capacitor 3 according to Figure 6 is implemented very similar to the first transistor 1 according to Figures 4 and 5. This offers the advantage that the first transistor device 1 and the capacitor 3 can be implemented by widely using the same process steps.

Referring to Figure 6, the capacitor 3 includes a first contact electrode 363 which forms the second circuit node N32 of the capacitor 3, and a second contact electrode 366 which forms the first circuit node N31 of the capacitor 3. The first contact electrode 363 is formed on top of the first surface 101 of the semiconductor body 100 and is separated from the semiconductor body 100 by an insulating layer 371. The second contact electrodes 366 is formed on top of the second surface 102 of the semiconductor body 100. Furthermore, the capacitor 3 according to Figure 6 includes doped semiconductor regions of the same type as the first transistor device 1. More specifically, the capacitor 3 includes a first doped region 31 corresponding to the drift region 11 of the first transistor device 1, second doped regions 32 corresponding to the body regions 12, third doped regions 33 corresponding to the source regions 13, and a fourth doped region 34 corresponding to the drain region 14. Furthermore, the capacitor 3 includes a plurality of trenches 30 in which first electrodes 35 corresponding to the gate electrodes 15 and second electrodes 37 corresponding to the field electrodes 17 are arranged. The first electrodes 35 are dielectrically insulated from the semiconductor body 100 by dielectric layers 36 corresponding to the gate dielectrics 16, and the second electrodes 37 are dielectrically insulated from the semiconductor body 100 by dielectric layers 38 corresponding to the field electrodes dielectrics 18.

Each of the first and second electrodes 35, 37 and the second and third doped regions 32, 33 are connected to the first contact electrode 363 through respective electrically conducting vias 362, 365 that extend through the insulating layer 371. The connection between the second electrodes 37 and the first contact electrodes 363 is only schematically illustrated in Figure 6. Vias that connect the second electrodes 37 to the first contact electrodes 366 are out of view in Figure 6. The second electrodes 37 may be connected to the first contact electrodes 363 in the same way in which the field electrodes 17 of the first transistor device 1 are connected to the source electrode 163.

In the capacitor 3 according to Figure 6, the first and second electrodes 35, 37 arranged in the trenches 30 and connected to the first contact electrode 363 form a first capacitor electrode, the dielectric layers 36, 38 form a capacitor dielectric, and the first and fourth doped region 31, 34 connected to the second contact electrode 366 form a second capacitor electrode. The second contact electrode 366 and the drain electrode 166 of the first transistor device 1 may be formed by the same electrode or metallization layer.

In the capacitor according to Figure 6, when a voltage is applied between the first and second contact electrodes 363, 366 in such a way that a PN junction formed between the first regions 31 of the first doping and the second regions 31, 32 of the second doping type is reverse biased, a space charge region expands in the first semiconductor region 31. This space charge region (depletion region), which is due to the reverse biased PN-junction and the first and second electrodes 35, 37 dielectrically insulated from the first doped region 31 is associated with storing charge carriers in the first region 31 and at the interface between the first and second electrodes 35, 37 and the dielectric layers 36, 38, so that the arrangement according to Figure 6 acts as a capacitor 3.

According to one example, the first, third and fourth regions 31, 33, 34 are N-type regions and the second regions 32 are P-type regions. In this example, a space charge region is formed in the first region 31 when a positive voltage is applied between the first and second circuit nodes 31, 32 of the capacitor 3.

As the voltage between the first and second contact electrodes 363, 366 increases mesa regions are arranged between the trenches 30 are completely depleted of charge carriers, which is associated with a reduction of the capacitance of the capacitor 3. In this way, the capacitor 3 according to Figure 6 has a voltage dependent capacitance that decreases as the voltage V3 applied between the first and second contact electrodes 363, 366 increases.

Figure 7 shows a modification of the capacitor 3 according to Figure 6. In the capacitor 3 according to Figure 7, the second and third doped regions 32, 33 and the first electrodes 35 are omitted, so that the first contact electrode 363 is only connected to the second electrodes 37, wherein the second electrodes 37 form the first capacitor electrode in this example. The second capacitor electrode is formed by the first and fourth doped regions 31, 34. In the capacitor 3 according to Figure 7, a space charge region (depletion region) that expands in the first doped region 31 when a respective voltage is applied between the first and second contact electrodes 363, 366 is governed only by the electrical potential applied to the second electrodes 37. In the same way as in the capacitor 3 according to Figure 6, the mesa regions are entirely depleted of charge carriers as the voltage V3 applied between the first and second circuit nodes N31, N32 increases, so that the capacitance of the capacitor C3 decreases as the voltage Vout 3 increases.

In Figure 2, voltage levels V31, V32 of voltage V3 at which the decrease of the capacitance slows down with a further increase of the voltage V3 represents those voltage level of the voltage V3 at which the mesa regions are entirely depleted.

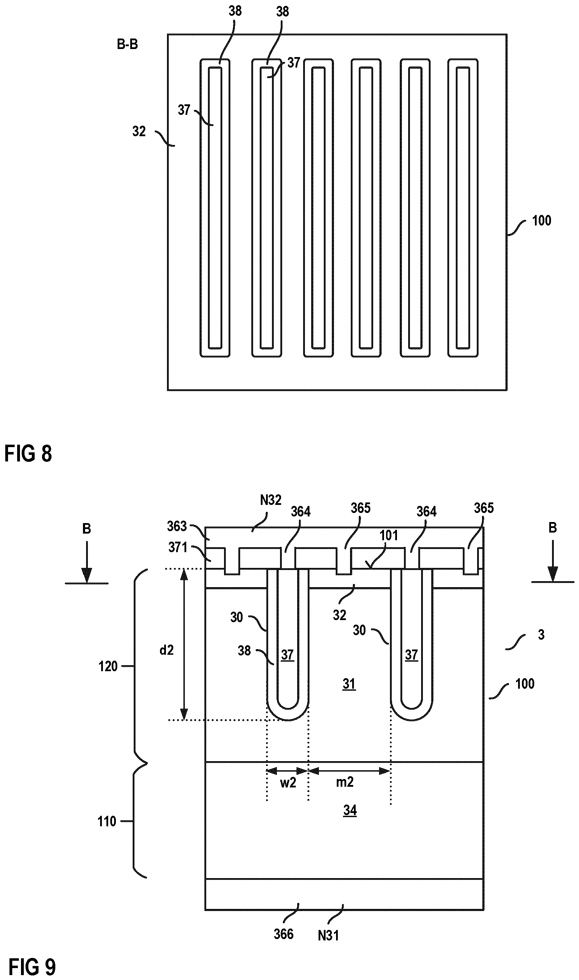

Figure 8 shows a horizontal cross-sectional view of a capacitor 3 of the type illustrated in Figure 7 in a section plane B-B illustrated in Figure 7. Referring to Figure 8, the electrodes 37 that form the first capacitor electrode may be implemented as elongated electrodes. In the following "basic capacitance" of the capacitor 3 denotes the capacitance when the voltage V3 applied to the capacitor is zero. This basis capacitance can be adjusted by suitably adjusting the number and the size, in particular the length, of the electrodes 37. Basically, the capacitance increases as the number and/or the size of the second electrodes 37 increases.

Figure 9 shows a modification of the capacitor 3 according to Figure 7. The capacitor 3 according to Figure 9 is different from the capacitor 3 according to Figure 7 in that it includes the second doped regions 32 connected to the first contact electrode 363. The second doped region 32 that has a doping type complementary to the doping type of the first region 31 may help to increase the voltage blocking capability of the capacitor 3 according to Figure 9 as compared to the capacitor 3 according to Figure 7.

In each of the capacitors illustrated in Figures 8-9, the voltage characteristic can be adjusted by suitably adjusting dimensions and mutual distances of the trenches 30 that include the second electrodes 37 (and, optionally, the first electrode 35). In Figures 7 and 9, d2 denotes a depth of the trenches 30, which is a dimension of the trenches 30 in the vertical direction, w2 denotes a width of the trenches 30, which is a dimension of the trenches 30 in a lateral direction perpendicular to the longitudinally direction, and m2 denotes a (shortest) distance between the trenches 30. The distance m2 between the trenches 30 equals a width of the mesa regions arranged between the trenches 30. According to one example, the trenches 30 of the capacitor 3 are implemented such that at least 1 of the following applies: (a) the trench depth d2 is larger than the trench depth d1 of the trenches with the gate electrodes 15 and the field electrodes 17 of the first transistor device 1; (b) the trench width w2 is larger than the width of the trenches with the gate electrodes 15 and the field electrodes 17 of the first transistor device 1; (c) the distance m2 between the trenches 30 is smaller than a distance m1 between the trenches with the gate electrodes 15 and the field electrodes 17 of the first transistor device 1.

By increasing the trench depth d2 and/or increasing the trench width w2 the basic capacitance can be increased. By reducing the distance m2 between the trenches 30 the voltage at which the mesa regions are entirely depleted can be reduced. Thus, by suitably adjusting the distance m2 between the trenches 30 the voltage level of the voltage V3 can be adjusted at which the capacitor 3 reaches its minimum capacitance.

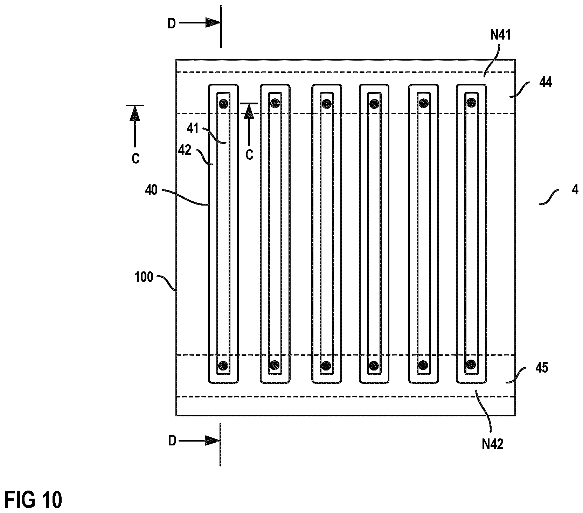

The resistor 4 of the protection circuit 4 can be implemented in various ways. Some examples are explained with reference to Figures 10-14 in the following.

According to one example illustrated in Figure 10, the resistor 4 includes a plurality of resistive conductors 41 wherein each of these conductors 41 is arranged in a respective trench 40 in the semiconductor body 100 and is electrically insulated from the semiconductor body 100 by an insulating layer 42. The conductors 41 may include any kind of resistive material, such as doped polysilicon. The insulating layers 42 may include any kind of insulating material, such as an oxide or a nitride.

Referring to Figure 10, each of the conductors 41 longitudinally extends in a lateral direction of the semiconductor body 100 and is connected to a first contact electrode 44 at a first longitudinal end and a second contact electrode 45 at a second longitudinal end opposite the first longitudinal end. The first and second contact electrodes 44, 45 may be arranged on top of the first surface 101 of the semiconductor body 100 and insulated from the semiconductor body 100. The first and second contact electrodes 44, 45 are illustrated in dashed lines in Figure 10. The contact electrodes 44, 45 may be connected to the resistive conductors 41 through electrically conducting vias which are schematically illustrated as bold dots in Figure 10.

An overall resistance of the resistor 4 can be adjusted by suitably selecting one or more of the following parameters: the length of the resistive conductors 41; a cross-sectional area of the resistive conductors 41 in a plane perpendicular to the longitudinally directions of the conductors 41; the resistive material of the resistive conductors 41; and the number of resistive conductors 41 that are connected in parallel. Basically, the longer the resistive conductors 41 the higher the resistance, the higher the lateral cross-sectional area the lower the resistance, and the higher the number of resistive conductors 41 the lower the resistance.

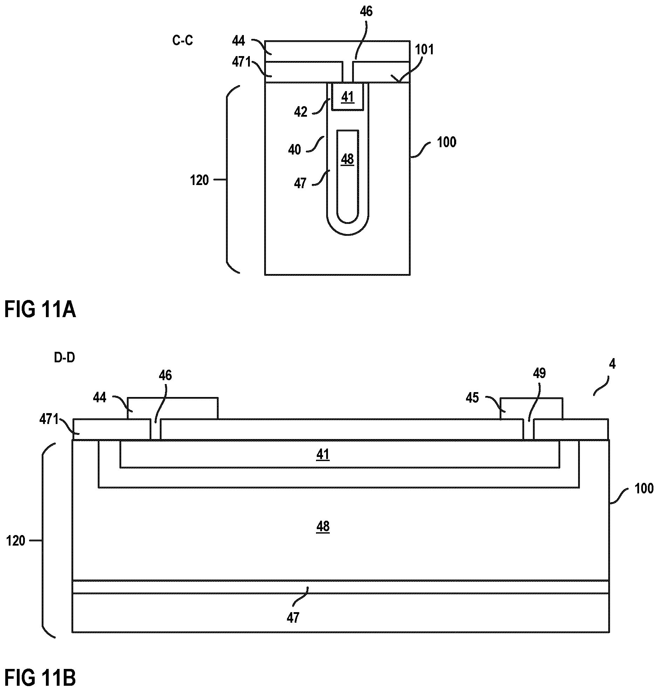

The resistive conductors 41 may be implemented in various ways. According to one example, the resistive conductors 41 are formed by the same process in which the gate electrodes 15 of the first transistor device 1 are formed. The insulating layer 42 separating the conductor 41 from the semiconductor body 100 may be formed by the same process in which the gate dielectrics 15 are formed in the first transistor device 1. Vertical cross-sectional views of a resistive conductor 41 of this type are illustrated in Figures 11A and 11B.

Figure 11A shows a vertical cross-sectional view of a conductor 41 in a first section plane C-C according to Figure 10, and Figure 11B shows a vertical cross-sectional view of the conductor 41 in a second section plane D-D according to Figure 10. The first section plane C-C is essentially perpendicular to the longitudinally direction of the conductor 41, and the second section plane D-D essentially extends in the longitudinal direction of the conductor 41.

In the example illustrated in Figures 11A and 11B, a further conductor 48 is arranged in the trench 40 in addition to the resistive conductor 41. The further conductor 48 may be formed by the same process in which the field electrodes 17 are formed in the first transistor device 1. The further conductor 48 is insulated from the semiconductor body 100 by an insulating layer 47, which may be formed by the same process in which the field electrodes dielectrics 18 are formed in the first transistor device 1.

Referring to Figure 11B, the contact electrodes 44, 45 may be arranged on top of an insulating layer 471 that separates the contact electrodes 44, 45 from the semiconductor body 100. In this example, the conductor 41 is connected to the first and second contact electrodes 44, 45 through electrically conducting vias 46, 49 that extend through the insulating layer 471. The further conductor 48 may be implemented as a floating conductor which is insulated from the contact electrodes 44, 45 and from the semiconductor body 100.

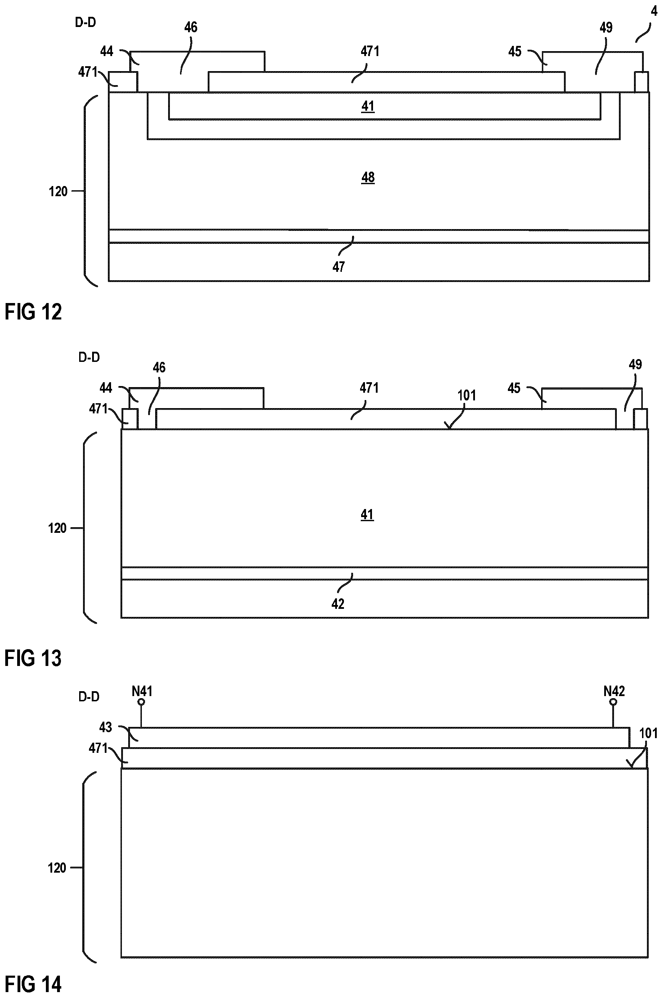

Figure 12 shows a modification of the resistor 4 illustrated in Figures 11A and 11B. In the resistor 4 according to Figure 12, the conductor 41 and the further conductor 48 arranged below the conductor 41 are both connected to each of the first and second contact electrodes 44, 45. In this example, both conductors 41, 48 contribute to the resistance of the resistor 4.

Figures 13 illustrates another example of the resistor 4. In this example, only the first resistive conductor 41 is arranged in each trench and is connected to the first and second contact electrodes 44, 45. Within the trench, the conductor 41 is insulated from the semiconductor body 100 by the insulating layer 42.

Figure 14 illustrates another example of the resistor 4. In this example, the resistor 4 includes a resistive layer 43 formed on top of the insulating layer 471. The second nodes N41, N42 for contacting the resistor formed by the resistive layer 43 are only schematically illustrated in Figure 14.

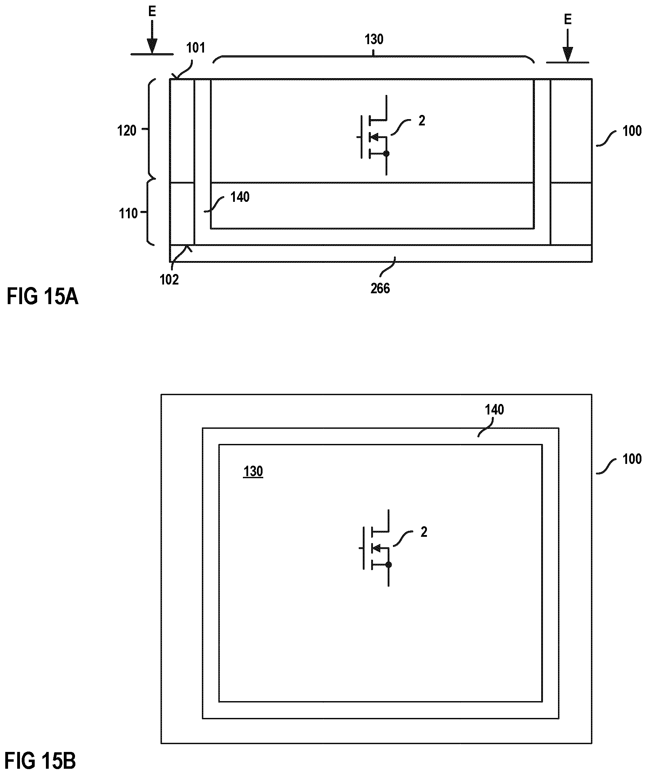

Figures 15A and 15B schematically illustrate one example for integrating the second transistor device 2 in the semiconductor body 100. Figure 15A shows a vertical cross-sectional view of a region 130 of the semiconductor body 100 in which the second transistor device 2 is integrated, and Figure 15B shows a top view of the region 130 of the semiconductor body 100 in which the second transistor device 2 is integrated. The region 130 in which the second transistor device 2 is integrated is referred to as second transistor region in the following.

Referring to Figures 15A and 15B, the second transistor region 130 is separated from a remainder of the semiconductor body 100 by an insulating region 140. This insulating region 140, in lateral directions of the semiconductor body 100, surrounds the second transistor region 130. In the vertical direction of the semiconductor body 100, the insulating region 140 extends from the first surface 101 through the semiconductor body 100 to the second surface 102. Those sections of the insulating region 140 that extend from the first surface 101 to the second surface 102 may be referred to as sidewall sections of the insulating region 140.

According to one example, on top of the second surface 102 an electrode 266 may be formed. This electrode may be formed by the same electrode layer or metallization layer that forms the drain electrode 166 of the first transistor device 1 and the second contact electrode 366 of the capacitor 3. In this example, the insulating region 140 includes a bottom section that separates the second transistor region 130 from the electrode layer 266. The sidewall sections and the bottom section form a well-like structure that surrounds the second transistor region 130.

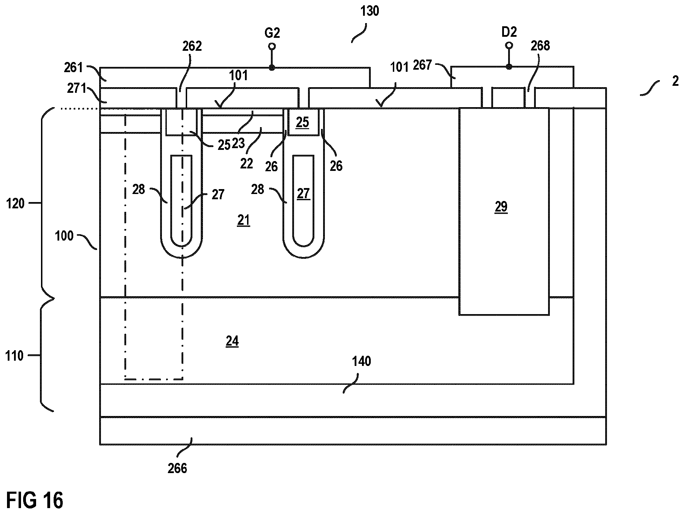

Figures 16 illustrates one example for implementing the second transistor device 2 in the second transistor region 130. More specifically, Figures 16 shows a vertical cross-sectional view of one section of the second transistor region 130 and the second transistor device 2 integrated therein.

In a similar way as the first transistor device 1 explained herein before, the second transistor device 2 may include a plurality of transistor cells 20. Each transistor cells 20 includes a drift region 21 of a first doping type, a body region 22 of a second doping type separating the drift region 21 from a source region 23 of the first doping type, and a drain region 24 of the first to doping type separated from the body region 22 by the drift region 21. Furthermore, each transistor cell 20 includes a gate electrode 25 dielectrically insulated from the body region 22 and configured to control a conducting channel in the body region 22 between the source region 23 and the drift region 21.

The gate electrodes 25 of the individual transistor cells 20 are connected to a gate conductor 261 that is formed on top of the first surface 101 of the semiconductor body 100 and is insulated from the semiconductor body 100 by an insulating layer 271. Electrically conducting vias 262 that extend through the insulating layer 271 connect the gate electrodes 25 to the gate conductor 261. The gate conductor 261 forms the first drive node G2 or is connected to the drive node G2 of the second transistor device 2.

The source and body regions 23, 22 are connected to a source electrode, which is out of view in the cross-sectional view illustrated in Figures 16. The source and body regions 23, 22 may be connected to the source electrode in the same way as the source and body regions 13, 12 of the first transistor device 1 are connected to the source electrode 161 of the first transistor device.

Optionally, each transistor cells 20 further includes a field electrode 27 that is dielectrically insulated from the drift region 21 by a field electrode dielectric 28. The field electrodes 27 are also connected to the source electrode (which is out of view in Figure 16).

Referring to Figure 16, the second transistor device 2 further includes a drain electrode 267 which is formed on top of the insulating layer 271, so that the drain electrode 267 is formed on top of the first surface 101. A doped connection region 29 extends from the first surface 101 down to the drain region 24 and is connected to the drain electrode 267 through electrically conducting vias 268 that extend through the insulating layer 271. The doped connection region 29 is highly doped in order to achieve a low resistance between the drain electrode 267 and the drain region 24 of the second transistor device 2.

Basically, the second transistor device is a vertical transistor device because the source regions 23 are spaced apart from the drain region 24 in the vertical direction of the semiconductor body 100. However, different from the first transistor device 1, which is also a vertical transistor device, the gate, source and drain electrodes 261, 267 of the second transistor device 2 of formed on top of the first surface 101 of the semiconductor body 100.

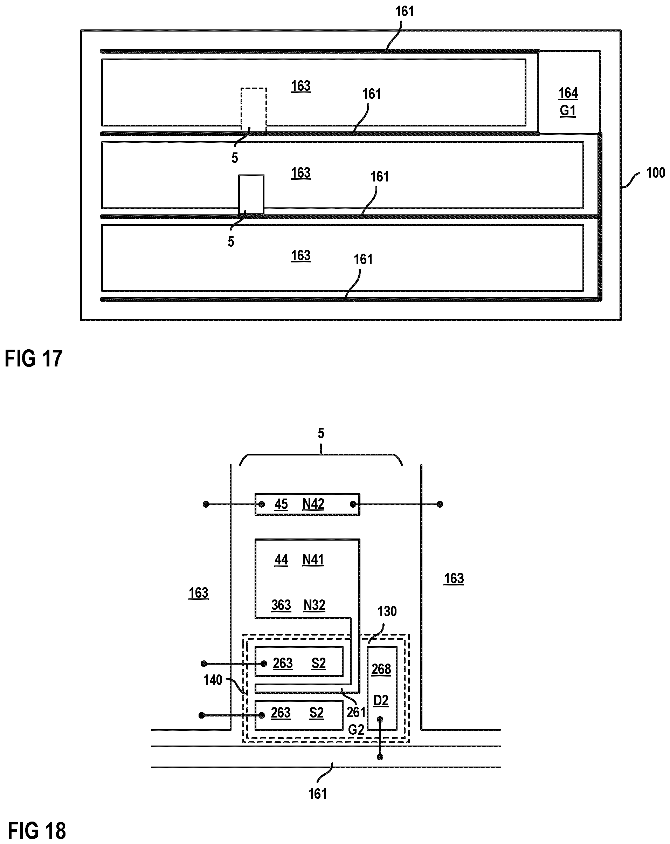

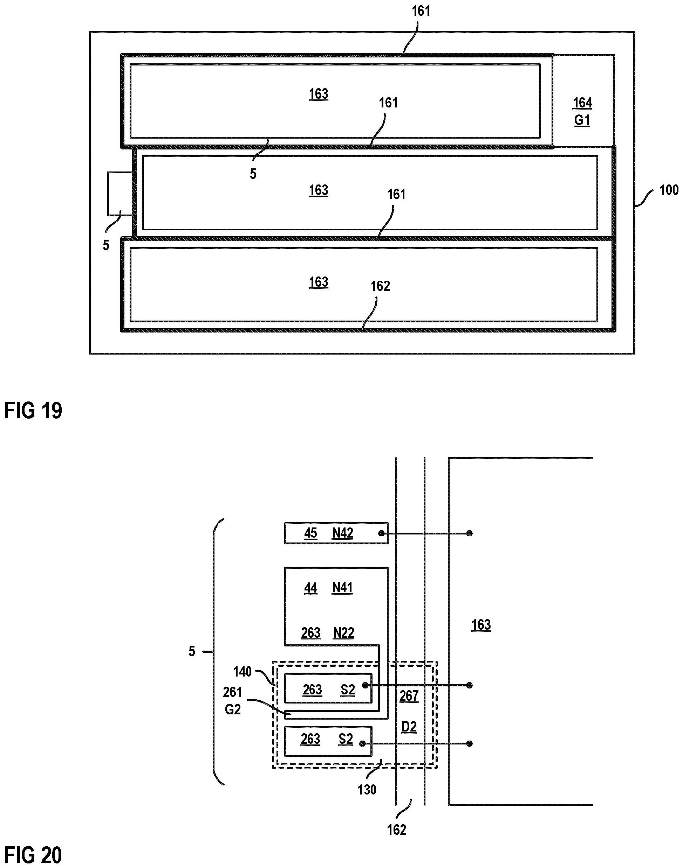

There are various ways for arranging the first transistor device 1 and the protection circuit 5 within the semiconductor body 100. Different examples are explained with reference to Figures 7-20 in the following. Figures 17 and 19 each show a top view of the overall semiconductor body 100, and Figures 18 and 20 each show a detailed top view of a section of the semiconductor body 100 in which the protection circuit 5 or a portion of the protection circuit 5 is integrated. In each of these examples, the semiconductor body 100 may include only one section in which the protection circuit 5 is integrated. This is illustrated in Figures 17 and 19 in which the solid lines labeled with reference number 5 schematically illustrated a section of the semiconductor body 100 in which the protection circuit 5 is integrated.

Alternatively, the semiconductor body 100 may include two or more sections in which the protection circuit 5 is integrated. In this case, the protection circuit 5 includes several sub-circuits that each include a second transistor device 2, a capacitor 3, and a resistor 4, wherein each of these sub-circuits is connected between the first and second load path node D1, S1 of the first transistor device 1. More specifically, each of these sub-circuits is connected between a source electrode 163 and the drain electrode 166 of the first transistor device 1. In Figure 17 the dashed line labeled with reference number 5 illustrates a further section of the semiconductor body 100 in which a portion of the protection circuit 5 may be integrated. Of course, the protection circuit 5 is not restricted to include only two sub-circuits circuits (as illustrated by the solid line and the dashed line in Figure 17) but may include a plurality of sub-circuits that each include a second transistor to, a capacitor 3, and a resistor 4.

Figures 17-20 show a top view of the first surface of the semiconductor body 100, so that the drain electrode 166, which is formed on top of the second surface 102 is out of view in these figures. Equivalently, the second contact electrode 366 of the capacitor 3, which may be formed by the same electrode or metallization layer as the drain electrode 166 of the first transistor device 1 is out of view in Figures 17-20.

Referring to Figures 17 and 19, the first transistor device may include several source electrodes 163 and several gate conductors 161, wherein the gate conductors 161 are electrically connected to a gate pad 164 formed on top of the first surface 101 of the semiconductor body 100. The gate pad 164 forms the drive node (gate node) G1 of the first transistor device 1. The gate pad 164 is insulated from the semiconductor body 100 by an insulating layer (not illustrated), for example.

Referring to Figure 17, the gate conductors 161, which may also be referred to as gate runners, may form a finger-like structure, wherein the fingers of the structure separate the source electrodes 163 from each other. According to another example illustrated in Figure 19, the gate runners 161 may entirely surround the source electrodes 163. In the finished device, the source electrodes 163 are electrically connected with each other by bond wires, clips, or the like, wherein the source electrodes 163 together form the second drive node and second load path node S2 of the first transistor device 1.

Figure 18 shows a top view of the section of the semiconductor body 100 according to Figures 17 in which the protection circuit 5 or a sub-circuit of the protection circuit 5 is integrated. For the ease of illustration, only the contact electrodes of the respective circuit elements of the protection circuit 5 are illustrated in Figure 18. Furthermore, the dashed lines in Figure 18 schematically illustrate the position of the insulation region 160 that surrounds the second transistor region 130, in which the second transistor device 2 is integrated.

In the example illustrated in Figure 18, the second transistor device 2 includes two source electrodes 263, wherein each of these source electrodes 263 is connected to at least one source electrode 163 of the first transistor device 1. Connections between the source electrodes 263 of the second transistor device 2 and the source electrode 163 of the first transistor device 1 are only schematically illustrated in Figure 18. These connections may be implemented using any kind of electrical conductors, such as bond wires. The drain electrode 268 of the second transistor device 2 is electrically connected to one of the gate runners 161 of the first transistor device 1. Furthermore, the gate conductor 261 of the second transistor device 2 is electrically connected to an electrode or metallization layer which at the same time forms the first contact electrode 363 of the capacitor 3 and the first contact electrode 44 of the resistor. The capacitor 3 is integrated in the semiconductor body 100 below this electrode or metallization layer. Furthermore, a portion of the resistor is integrated in the semiconductor body below this electrode or metallization layer and extends in the semiconductor body 100 towards the second contact electrode 45 of the resistor. The second contact electrode 45 of the resistor 4 is connected to at least one of the source electrodes 163 of the first transistor device 1.

In the example illustrated in Figure 17, the protection circuit 5 is integrated in an inner region of the semiconductor body. In the inner region of the semiconductor body 100 transistor cells of the first transistor device 1 are integrated. Thus, the area in which the protection circuit 5 is integrated is surrounded by those sections of the semiconductor body 100 that includes transistor cells of the first transistor device. Such transistor cells, however, are not illustrated in Figure 17.

In the example illustrated in Figure 19, the area in which the protection circuit 5 is integrated is arranged in an edge region of the semiconductor body 100. The edge region does not include transistor cells of the first transistor device 1. The protection circuit 5 according to Figure 20 is different from the protection second 5 according to Figure 18 in that the drain electrode 267 of the second transistor device 2 is formed by a portion of one of the gate runners 162. Everything else explained was regard to the protection circuit 5 according to Figure 18 applies to the protection circuit according to Figure 20 accordingly.

## Claims

1.  An electronic circuit, comprising:

    a first transistor device (1) comprising a first drive node (G1), a second drive node (S1), and a load path (D1-S1); and
    a protection circuit (5) coupled to the first and second drive nodes (G1, S1) and the load path (D1-S1) of the first transistor device (1),
    wherein the protection circuit (5) comprises:

a second transistor device (2) comprising a first drive node (G2), a second drive node (S2), and a load path (D2-S2) connected between the first and second drive nodes (G1, S1) of the first transistor device (1); and a capacitor (3) coupled between the load path (D1-S1) of the first transistor device (1) and the first drive node (G2) of the second transistor device (2),

**characterised in that**

a capacitance of the capacitor (3) is voltage dependent such that the capacitance decreases as a voltage (V3) across the capacitor (3) increases.

2. The electronic circuit according to claim 1,
wherein the protection circuit (5) further comprises a resistor (4) connected between the first and second drive nodes (G2, S2) of the second transistor device (2).

3. The electronic circuit of claim 1 or 2, wherein the capacitor (3) comprises:

a plurality of capacitor trenches (30) each extending from a first surface (101) into a semiconductor body (100);
a plurality of semiconductor mesa regions (31), wherein each semiconductor mesa region (31) is formed between a respective pair of the plurality of capacitor trenches (30); and
a trench electrode (35, 37) arranged in each of the capacitor trenches (30) and dielectrically insulated from the semiconductor body (100),
wherein the semiconductor mesa regions (31) are connected to a first node (N31) of the capacitor (3), and
wherein the trench electrodes (35, 37) in each of the plurality of the capacitor trenches (30) are connected to a second node (N32) of the capacitor (3).

4. The electronic circuit of claim 3,

wherein the semiconductor mesa regions (31) are doped regions of a first doping type,
wherein the capacitor (3) further comprises a plurality of doped regions (32) of a second doping type complementary to the first doping type,
wherein each of the doped regions (32) of the second doping type adjoins a respective one of the semiconductor mesa regions (31) and is connected to the second node (N32) of the capacitor (3).

5. The electronic circuit of claim 3 or 4,

wherein the semiconductor body (100) comprises a first semiconductor layer (110) and a second semiconductor layer (120) formed on top of the first semiconductor layer (110),
wherein the capacitor trenches (30) are formed in the second semiconductor layer (120).

6. The electronic circuit of any one of claims 3 to 5,

wherein the capacitor further comprises a first electrode layer (366) formed on top of a surface of the first semiconductor layer (110) facing away from the second semiconductor layer (120), and
wherein the first electrode layer (366) forms the first circuit node (N31) of the capacitor (3).

7. The electronic circuit of any one of claims 3 to 6,

wherein the capacitor further comprises a second electrode layer (363) formed on top of a surface of the second semiconductor layer (120) facing away from the first semiconductor layer (110), and
wherein the second electrode layer (363) forms the second circuit node (N32) of the capacitor (3).

8. The electronic circuit of any one of the preceding claims,

wherein the first transistor device (1) comprises a plurality of transistor cells (10) integrated in a semiconductor body (100),
wherein each transistor cell (10) comprises a field electrode (17) arranged in a field electrode trench extending from a first surface (101) into the semiconductor body (100) and dielectrically insulated from a drift region (11) of the transistor cell (10).

9. The electronic circuit of any one of claims 3 to 8, wherein at least one of the following applies:

a depth (d3) of the capacitor trenches (30) is larger than a depth (d1) of the field electrode trenches,
a width (w3) of the capacitor trenches (30) is larger than a width (w1) of the field electrode trenches,
a width (m3) of the semiconductor mesa regions (31) between the capacitor trenches (30) is smaller than a width (m1) of semiconductor mesa regions between field electrode trenches.

10. The electronic circuit of any one of the preceding claims,
wherein the first transistor device (1), the second transistor device (2), the capacitor (3), and the resistor (4) are integrated in the same semiconductor body (100).

11. The electronic circuit of claim 10,
wherein the second transistor device (2) is integrated in a semiconductor region (130) that is dielectrically insulated from a remainder of the semiconductor body (100).

12. The electronic circuit of any one of claims 10 to 11,

wherein the semiconductor body includes an inner region, wherein the transistor cells (10) of the first transistor device (1) are integrated in the inner region, and
wherein the protection circuit (5) is integrated in the inner region.

13. The electronic circuit of any one of claims 10 to 11,

wherein the semiconductor body includes an inner region, in which the transistor cells (10) of the first transistor device (1) are integrated, and an edge region, and
wherein the protection circuit (5) is integrated in the edge region

14. The electronic circuit of to any one of the preceding claims,

wherein the load path (D1-S1) of the first transistor device (1) comprises a first load path node (D1) and a second load path node (S1), and
wherein the capacitor (3) is connected between the first load path node (D1) of the first transistor device (1) and the first drive node (G2) of the second transistor device.

15. A method, comprising:

switching off a first transistor device (1) by a protection circuit (5),
wherein the first transistor device (1) comprises a first drive node (G1), a second drive node (S1), and a load path (D1-S1),
wherein the protection circuit is coupled to the first and second drive nodes (G1, S1) and the load path (D1-S1) of the first transistor device (1) and comprises:

a second transistor device (2) comprising a first drive node (G2), a second drive node (S2), and a load path (D2-S2) connected between the first and second drive nodes (G1, S1) of the first transistor device (1), and
a capacitor (3) coupled between the load path (D1-S1) of the first transistor device (1) and the first drive node (G2) of the second transistor device (2), **characterised in that** the capacitance of the capacitor (3) is voltage dependent such that the capacitance decreases as a voltage (V3) across the capacitor (3) increases.

**Patentansprüche**

1. Elektronische Schaltung, die aufweist:

ein erstes Transistorbauelement (1), das einen ersten Ansteuerknoten (G1), einen zweiten Ansteuerknoten (S1) und einen Lastpfad (D1-S1) aufweist; und
eine Schutzschaltung (5), die an den ersten und den zweiten Ansteuerknoten (G1, S1) und den Lastpfad (D1-S1) des ersten Transistorbauelements (1) gekoppelt ist,
wobei die Schutzschaltung (5) aufweist:

ein zweites Transistorbauelement (2), das einen ersten Ansteuerknoten (G2), einen zweiten Ansteuerknoten (S2) und einen Lastpfad (D2-S2), der zwischen den ersten und den zweiten Ansteuerknoten (G1, S1) des ersten Transistorbauelements (1) geschaltet ist, aufweist; und

einen Kondensator (3), der zwischen den Lastpfad (D1-S1) des ersten Transistorbauelements (1) und den ersten Ansteuerknoten (G2) des zweiten Transistorbauelements (2) gekoppelt ist,

**dadurch gekennzeichnet, dass**

eine Kapazität des Kondensators (3) derart spannungsabhängig ist, dass die Kapazität abnimmt, wenn eine Spannung (V3) über dem Kondensator (3) zunimmt.

2. Elektronische Schaltung nach Anspruch 1,

wobei die Schutzschaltung (5) ferner einen Widerstand (4) aufweist, der zwischen den ersten und den zweiten Ansteuerknoten (G2, S2) des zweiten Transistorbauelements (2) geschaltet ist.

3. Elektronische Schaltung nach Anspruch 1 oder 2, wobei der Kondensator (3) aufweist:

mehrere Kondensatorgräben (30), die sich jeweils von einer ersten Oberfläche (101) in einen Halbleiterkörper (100) erstrecken;

mehrere Halbleiter-Mesagebiete (31), wobei jedes Halbleiter-Mesagebiet (31) zwischen einem jeweiligen Paar der mehreren Kondensatorgräben (30) ausgebildet ist; und

eine Grabenelektrode (35, 37), die in jedem der Kondensatorgräben (30) angeordnet und von dem Halbleiterkörper (100) dielektrisch isoliert ist,

wobei die Halbleiter-Mesagebiete (31) an einen ersten Knoten (N31) des Kondensators (3) angeschlossen sind, und

wobei die Grabenelektroden (35, 37) in jedem der mehreren Kondensatorgräben (30) an einen zweiten Knoten (N32) des Kondensators (3) angeschlossen sind.

4. Elektronische Schaltung nach Anspruch 3,

wobei die Halbleiter-Mesagebiete (31) dotierte Gebiete eines ersten Dotierungstyps sind,

wobei der Kondensator (3) ferner mehrere dotierte Gebiete (32) eines zweiten Dotierungstyps, der zu dem ersten Dotierungstyp komplementär ist, aufweist,

wobei jedes der dotierten Gebiete (32) des zweiten Dotierungstyps an ein jeweiliges der Halbleiter-Mesagebiete (31) angrenzt und an den zweiten Knoten (N32) des Kondensators (3) angeschlossen ist.

5. Elektronische Schaltung nach Anspruch 3 oder 4,

wobei der Halbleiterkörper (100) eine erste Halbleiterschicht (110) und eine zweite Halbleiterschicht (120), die auf der ersten Halbleiterschicht (110) ausgebildet ist, aufweist,

wobei die Kondensatorgräben (30) in der zweiten Halbleiterschicht (120) ausgebildet sind.

6. Elektronische Schaltung nach einem der Ansprüche 3 bis 5,

wobei der Kondensator ferner eine erste Elektrodenschicht (366) aufweist, die auf einer Oberfläche der ersten Halbleiterschicht (110) ausgebildet ist, die von der zweiten Halbleiterschicht (120) abgewandt ist, und

wobei die erste Elektrodenschicht (366) den ersten Schaltungsknoten (N31) des Kondensators (3) bildet.

7. Elektronische Schaltung nach einem der Ansprüche 3 bis 6,

wobei der Kondensator ferner eine zweite Elektrodenschicht (363) aufweist, die auf einer Oberfläche der zweiten Halbleiterschicht (120) ausgebildet ist, die von der ersten Halbleiterschicht (110) abgewandt ist, und

wobei die zweite Elektrodenschicht (363) den zweiten Schaltungsknoten (N32) des Kondensators (3) bildet.

8. Elektronische Schaltung nach einem der vorhergehenden Ansprüche,

wobei das erste Transistorbauelement (1) mehrere Transistorzellen (10) aufweist, die in einem Halbleiterkörper (100) integriert sind,

wobei jede Transistorzelle (10) eine Feldelektrode (17) aufweist, die in einem Feldelektrodengraben angeordnet ist, der sich von einer ersten Oberfläche (101) in den Halbleiterkörper (100) erstreckt, und die von einem Driftgebiet (11) der Transistorzelle (10) dielektrisch isoliert ist.

9. Elektronische Schaltung nach einem der Ansprüche 3 bis 8, wobei mindestens eines der Folgenden zutrifft:

   eine Tiefe (d3) der Kondensatorgräben (30) ist größer als eine Tiefe (d1) der Feldelektrodengräben,
   eine Breite (w3) der Kondensatorgräben (30) ist größer als eine Breite (w1) der Feldelektrodengräben,
   eine Breite (m3) der Halbleiter-Mesagebiete (31) zwischen den Kondensatorgräben (30) ist kleiner als eine Breite (m1) von Halbleiter-Mesagebieten zwischen Feldelektrodengräben.

10. Elektronische Schaltung nach einem der vorhergehenden Ansprüche,
    wobei das erste Transistorbauelement (1), das zweite Transistorbauelement (2), der Kondensator (3) und der Widerstand (4) in demselben Halbleiterkörper (100) integriert sind.

11. Elektronische Schaltung nach Anspruch 10,
    wobei das zweite Transistorbauelement (2) in einem Halbleitergebiet (130) integriert ist, das von einem Rest des Halbleiterkörpers (100) dielektrisch isoliert ist.

12. Elektronische Schaltung nach einem der Ansprüche 10 bis 11,

    wobei der Halbleiterkörper einen Innenbereich aufweist, wobei die Transistorzellen (10) des ersten Transistorbauelements (1) in dem Innenbereich integriert sind, und
    wobei die Schutzschaltung (5) in dem Innenbereich integriert ist.

13. Elektronische Schaltung nach einem der Ansprüche 10 bis 11,

    wobei der Halbleiterkörper einen Innenbereich, in dem die Transistorzellen (10) des ersten Transistorbauelements (1) integriert sind, und einen Randbereich aufweist, und
    wobei die Schutzschaltung (5) in dem Randbereich integriert ist.

14. Elektronische Schaltung nach einem der vorhergehenden Ansprüche,

    wobei der Lastpfad (D1-S1) des ersten Transistorbauelements (1) einen ersten Lastpfadknoten (D1) und einen zweiten Lastpfadknoten (S1) aufweist, und
    wobei der Kondensator (3) zwischen den ersten Lastpfadknoten (D1) des ersten Transistorbauelements (1) und den ersten Ansteuerknoten (G2) des zweiten Transistorbauelements geschaltet ist.

15. Verfahren, das aufweist:

    Ausschalten eines ersten Transistorbauelements (1) durch eine Schutzschaltung (5),
    wobei das erste Transistorbauelement (1) einen ersten Ansteuerknoten (G1), einen zweiten Ansteuerknoten (S1) und einen Lastpfad (D1-S1) aufweist,
    wobei die Schutzschaltung an den ersten und den zweiten Ansteuerknoten (G1, S1) und den Lastpfad (D1-S1) des ersten Transistorbauelements (1) gekoppelt ist und aufweist:

    ein zweites Transistorbauelement (2), das einen ersten Ansteuerknoten (G2), einen zweiten Ansteuerknoten (S2) und einen Lastpfad (D2-S2), der zwischen den ersten und den zweiten Ansteuerknoten (G1, S1) des ersten Transistorbauelements (1) geschaltet ist, aufweist, und
    einen Kondensator (3), der zwischen den Lastpfad (D1-S1) des ersten Transistorbauelements (1) und den ersten Ansteuerknoten (G2) des zweiten Transistorbauelements (2) gekoppelt ist,
    **dadurch gekennzeichnet, dass**
    die Kapazität des Kondensators (3) derart spannungsabhängig ist, dass die Kapazität abnimmt, wenn eine Spannung (V3) über dem Kondensator (3) zunimmt.

**Revendications**

1. Un circuit électronique, comprenant :

   un premier dispositif (1) à transistor comprenant un premier nœud (G1) de commande, un deuxième nœud (S1) de commande et un chemin (D1-S1) de charge ; et

un circuit (5) de protection connecté au premier et au deuxième nœuds (G1, S1) de commande et au chemin (D1-S1) de charge du premier dispositif (1) à transistor,

dans lequel le circuit (5) de protection comprend :

un deuxième dispositif (2) à transistor comprenant un premier nœud (G2) de commande, un deuxième nœud (S2) de commande et un chemin (D2-S2) de charge monté entre les premier et deuxième nœuds (G1, S1) de commande du premier dispositif (1) à transistor ; et

un condensateur (3) monté entre le chemin (D1-S1) de charge du premier dispositif (1) à transistor et le premier nœud (G2) de commande du deuxième dispositif (2) à transistor,

**caractérisé en ce qu'**une capacité du condensateur (3) dépend de la tension de manière à ce que la capacité diminue au fur et à mesure que la tension (V3) aux bornes du condensateur (3) s'élève.

2. Le circuit électronique suivant la revendication 1,

dans lequel le circuit (5) de protection comprend en outre une résistance (4) montée entre le premier et le deuxième nœuds (G2, S2) de commande du deuxième dispositif (2) à transistor.

3. Le circuit électronique suivant la revendication 1 ou 2, dans lequel le condensateur (3) comprend :

une pluralité de tranchées (30) de condensateur s'étendant chacune à partir d'une première surface (101) dans un corps (100) à semiconducteur ;

une pluralité de régions (31) mésa de semiconducteur, dans lequel chaque région (31) mésa de semiconducteur est formée entre une paire respective de la pluralité de tranchées (30) de condensateur ; et

une électrode (35, 37) de tranchée disposée dans chacune des tranchées (30) de condensateur et isolée diélectriquement du corps (100) à semiconducteur,

dans lequel les régions (31) mésa de semiconducteur sont connectées à un premier nœud (N31) du condensateur (3), et

dans lequel les électrode (35, 37) de tranchée dans chacune de la pluralité de tranchées (30) de condensateur sont connectés à un deuxième nœud (N32) du condensateur (3).

4. Le circuit électronique suivant la revendication 3,

dans lequel les régions (31) mésa de semiconducteur sont des régions dopées d'un premier type de dopage,

dans lequel le condensateur (3) comprend en outre une pluralité de régions (32) dopées d'un deuxième type de dopage complémentaire du premier type de dopage,

dans lequel chacune des régions (32) dopées du deuxième type de dopage est contiguë à l'une respective des régions (31) mésa de semiconducteur et est connectée au deuxième nœud (N32) du condensateur (3).

5. Le circuit électronique suivant la revendication 3 ou 4,

dans lequel le corps (100) à semiconducteur comprend une première couche (110) de semiconducteur et une deuxième couche (120) de semiconducteur formée au sommet de la première couche (110) de semiconducteur,

dans lequel les tranchées (30) de condensateur sont formées dans la deuxième couche (120) de semiconducteur.

6. Le circuit électronique suivant l'une quelconque des revendications 3 à 5,

dans lequel le condensateur comprend en outre une première couche (366) d'électrode formée au sommet d'une surface de la première couche (110) de semiconducteur en face loin de la deuxième couche (120) de semiconducteur, et

dans lequel la première couche (366) d'électrode forme le premier nœud (N31) de circuit du condensateur (3).

7. Le circuit électronique suivant l'une quelconque des revendications 3 à 6,

dans lequel le condensateur comprend en outre une deuxième couche (363) d'électrode formée au sommet d'une surface de la deuxième couche (120) de semiconducteur en face loin de la première couche (110) de semiconducteur, et

dans lequel la deuxième couche (363) d'électrode forme le deuxième nœud (N32) de circuit du condensateur (3).

8. Le circuit électronique suivant l'une quelconque des revendications précédentes,

dans lequel le premier dispositif (1) à transistor comprend une pluralité de cellules (10) de transistor intégrées dans un corps (100) à semiconducteur,

dans lequel chaque cellule (10) de transistor comprend une électrode (17) de champ disposée dans une tranchée d'électrode de champ s'étendant à partir d'une première surface (101) dans le corps (100) à semiconducteur et isolée diélectriquement d'une région (11) de migration de la cellule (10) de transistor.

9. Le circuit électronique suivant l'une quelconque des revendications 3 à 8, dans lequel au moins l'un de ce qui suit s'applique :

une profondeur (d3) des tranchées (30) du condensateur est plus grande qu'une profondeur (d1) des tranchées d'électrode de champ,

une largeur (w3) des tranchées (30) du condensateur est plus grande qu'une largeur (w1) des tranchées d'électrode de champ,

une largeur (m3) des régions (31) mésa de semiconducteur entre les tranchées (30) du condensateur est plus petite qu'une largeur (m1) de régions mésa de semiconducteur entre des tranchées d'électrode de champ.

10. Le circuit électronique suivant l'une quelconque des revendications précédentes,

dans lequel le premier dispositif (1) à transistor, le deuxième dispositif (2) à transistor, le condensateur (3) et la résistance (4) sont intégrés dans le même corps (100) à semiconducteur.

11. Le circuit électronique suivant la revendication 10,

dans lequel le deuxième dispositif (2) à transistor est intégré dans une région (130) à semiconducteur, qui est isolée diélectriquement du reste du corps (100) à semiconducteur.

12. Le circuit électronique suivant l'une quelconque des revendications 10 à 11,

dans lequel le corps à semiconducteur comprend une région intérieure, dans lequel les cellules (10) de transistor du premier dispositif (1) à transistor sont intégrées dans la région intérieure,

dans lequel le circuit (5) de protection est intégré dans la région intérieure.

13. Le circuit électronique suivant l'une quelconque des revendications 10 à 11,

dans lequel le corps à semiconducteur comprend une région intérieure, dans laquelle les cellules (10) de transistor du premier dispositif (1) à transistor sont intégrées, et une région de bord, et

dans lequel le circuit (5) de protection est intégré dans le région de bord.

14. Le circuit électronique suivant l'une quelconque des revendications précédentes,

dans lequel le chemin (D1-S1) de charge du premier dispositif (1) à transistor comprend un premier nœud (D1) de chemin de charge et un deuxième nœud (S1) de chemin de charge, et

dans lequel le condensateur (3) est monté entre le premier nœud (D1) de chemin de charge du premier dispositif (1) à transistor et le premier nœud (G2) de commande du deuxième dispositif à transistor.

15. Un procédé, comprenant :

mettre hors circuit un premier dispositif (1) à transistor par un circuit (5) de protection,

dans lequel le premier dispositif (1) à transistor comprend un premier nœud (G1) de commande, un deuxième nœud (S1) de commande et un chemin (D1-S1) de charge,

dans lequel le circuit de protection est connecté au premier et au deuxième nœuds (G1, S1) de commande et au chemin (D1-S1) de charge du premier dispositif (1) à transistor et comprend :

un deuxième dispositif (2) à transistor comprenant un premier nœud (G2) de commande, un deuxième nœud (S2) de commande et un chemin (D2-S2) de charge monté entre les premier et deuxième nœuds (G1, S1) de commande du premier dispositif (1) à transistor, et

un condensateur (3) monté entre le chemin (D1-S1) de charge du premier dispositif (1) à transistor et le premier nœud (G2) de commande du deuxième dispositif (2) à transistor,

**caractérisé en ce que** la capacité du condensateur (3) dépend de la tension, de manière à ce que la capacité diminue au fur et à mesure que la tension (V3) aux bornes du condensateur (3) s'élève.

**FIG 1**

**FIG 2**

D3, N31

G3

3

S3, N32

FIG 3

FIG 4

FIG 5

FIG 6

FIG 7

B-B

38    38

37

37

32

100

**FIG 8**

N32    364    365    364    365

363

B    371    101    B

30    32

d2    30    3

120    38    37    37    100

31

w2    m2

110    34

366    N31

**FIG 9**

FIG 10

FIG 11A

FIG 11B

**FIG 12**

**FIG 13**

**FIG 14**

FIG 15A

FIG 15B

FIG 16

FIG 17

FIG 18

161

163    161

164
G1

5

163    161

5

163    161

100

163    162

**FIG 19**

45   N42

44   N41

263   N22

163

5

140
261
G2

263   S2

263   S2

267

D2

130

162

**FIG 20**

**EP 4 407 871 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4677324 A